# EUROPEAN PATENT APPLICATION

(11) **EP 4 697 097 A1**
(43) Date of publication of application: **18.02.2026**
(21) Application number: 24895465.3
(22) Date of filing: 23.05.2024
(51) Int. Cl.: G03F 7/004, G03F 7/027, C09D 4/06, C09D 4/02, C08F 220/14, C08F 220/18, C08F 220/20, C08F 220/24, G03F 7/00, G03H 1/02

(54) **NON-FILM-FORMING MATRIX, PHOTOPOLYMER, FILM, PREPARATION METHOD AND SUBSTRATE**

(30) Priority: 27.11.2023 CN 202311603806
(71) Applicant: Shen Zhen Holy Zen Technology Co., Ltd., Shenzhen, Guangdong 518000 (CN)
(72) Inventor: SHEN, Bozhong, Shenzhen, Guangdong 518000 (CN)
(74) Representative: Mirlach, Xiaolu
(86) International application number: PCT/CN2024/094884
(87) International publication number: WO 2025/112355

(57) **Abstract**

The present application relates to the technical field of volume holographic display materials, and particularly relates to a non-film-forming matrix, a photopolymer, a film, a preparation method, and a printing stock. The method for preparing a photopolymer film includes the steps of: proportionally weighing methyl methacrylate, a low-Tg acrylic monomer, a cross-linked acrylic monomer, a rigid pendant group monomer, a fluorine-containing or silicon-containing acrylic monomer, and a free radical thermal initiator in percentage by mass to serve as a matrix, where in percentage by mass, the methyl methacrylate is 40-85%, the low-Tg acrylic monomer is 0-50%, the cross-linked acrylic monomer is 0-20%, the rigid pendant group monomer is 5-20%, the fluorine-containing or silicon-containing acrylic monomer is 4-20%, and the free radical thermal initiator is 0.5-5%; heating and refluxing the matrix in a solvent 1 for 1-8 hours to obtain a non-film-forming matrix; and proportionally weighing the non-film-forming matrix, a high-refractive-index monomer, a visible light trapping agent, and a photoinitiator to serve as a raw material I, where in percentage by mass, the non-film-forming matrix is 40-80%, the high-refractive-index monomer is 10-45%, the visible light trapping agent is 0.01-5%, and the photoinitiator is 1-10%.

## Description

### FIELD OF TECHNOLOGY

The present application relates to the technical field of volume holographic display materials, in particular to a non-film-forming matrix, a photopolymer, a film, a preparation method, and a printing stock.

### BACKGROUND

Current augmented reality (AR)-based optical waveguide sheet technologies are divided into three generations, including the first generation of array-type optical waveguides, the second generation of surface relief grating optical waveguides, and the third generation of volume holographic optical waveguides. The third generation of volume holographic optical waveguides are achieved through thin photosensitive coatings, the thin photosensitive coatings form volume holographic gratings via laser interference exposure, and a refractive index difference between matrices at bright fringes and dark fringes of the volume holographic gratings is known as refractive index modulation.

Materials for fabricating the volume holographic gratings usually include silver salt materials, dichromated gelatin, photosensitive high polymer materials, etc. The photosensitive high polymer materials have advantages such as high sensitivity, high resolution, high diffraction efficiency, wide spectral response, simple processing, high tolerance, and stable storage, thus being ideal materials for recording volume holographic image information. The photosensitive high polymer materials can be divided into three categories, including a photopolymerized type, a photocrosslinked type, and a photodecomposed type, and photopolymers are photopolymerized materials.

During the production of current photopolymers, protective films are coated with unexposed photopolymers, oven-dried, and then covered with protective films. However, since existing photopolymers generally adopt an ethylene-vinyl acetate copolymer (EVA) or a partially fluorine-substituted high polymer of the EVA as a matrix to prepare films, the films adhere to the protective films after photocuring, and it is unable to completely remove the protective films and achieve complete transfer printing during use, thereby greatly limiting applications of the photopolymers.

### SUMMARY

The present application provides a method for preparing a photopolymer film, which includes the steps of:
proportionally weighing methyl methacrylate, a low-Tg acrylic monomer, a cross-linked acrylic monomer, a rigid pendant group monomer, a fluorine-containing or silicon-containing acrylic monomer, and a free radical thermal initiator in percentage by mass to serve as a matrix, where in percentage by mass, the methyl methacrylate is 40-85%, the low-Tg acrylic monomer is 0-50%, the cross-linked acrylic monomer is 0-20%, the rigid pendant group monomer is 5-20%, the fluorine-containing or silicon-containing acrylic monomer is 4-20%, and the free radical thermal initiator is 0.5-5%;
heating and refluxing the matrix in a solvent 1 for 1-8 hours to obtain a non-film-forming matrix;
proportionally weighing the non-film-forming matrix, a high-refractive-index monomer, a visible light trapping agent, and a photoinitiator to serve as a raw material I, where in percentage by mass, the non-film-forming matrix is 40-80%, the high-refractive-index monomer is 10-45%, the visible light trapping agent is 0.01-5%, and the photoinitiator is 1-10%;
stirring and dissolving the raw material I in a solvent 2 to obtain a photopolymer solution;
fabricating a volume holographic grating master plate with a positioning mark;
coating the photopolymer solution onto a protective film and oven-drying to form a photopolymer coating, and covering the photopolymer coating with a protective film to obtain a photopolymer intermediate;
replicating a volume holographic grating on the volume holographic grating master plate onto the photopolymer intermediate to obtain a photopolymer film with a volume holographic grating; and
performing ultraviolet (UV) irradiation and heating on the photopolymer film.

The present application further discloses a photopolymer, which includes, in percentage by mass, 50-80% of a matrix and 20-50% of a compound base; where the compound base includes:
70-90% of a high-refractive-index monomer,
0.1-10% of a visible light trapping agent, and
9-20% of a photoinitiator; and
where in percentage by mass, the matrix includes:
   40-85% of methyl methacrylate,
   0-50% of a low-Tg acrylic monomer,
   0-20% of a cross-linked acrylic monomer,
   5-20% of a rigid pendant group monomer,
   4-20% of a fluorine-containing or silicon-containing acrylic monomer, and
   0.5-5% of a free radical thermal initiator.

Optionally, the low-Tg acrylic monomer is one or more of ethyl acrylate (EA), butyl acrylate (BA), 2-ethylhexyl acrylate (2-EHA), lauryl acrylate, and dodecyl acrylate.

Optionally, the cross-linked acrylic monomer is one or more of hydroxyethyl acrylate (HEA), hydroxyethyl methacrylate (HEMA), acrylamide (AAM), N-methylol acrylamide (NMA), diacetone acrylamide (DAAM), acetoacetoxyethyl methacrylate (AAEM), glycidyl methacrylate (GMA), and dimethylaminoethyl methacrylate (DMAEMA); and/or
the rigid pendant group monomer is one or more of isobornyl methacrylate (IBOA), dicyclopentadiene and a derivative thereof, and adamantyl acrylate.

Optionally, the fluorine-containing acrylic monomer is one or more of trifluoroethyl acrylate (TFEA), trifluoroethyl methacrylate (TFEMA), hexafluorobutyl acrylate (HFBA), and dodecafluoroheptyl methacrylate (DFMA); and
the silicon-containing acrylic monomer is one or more of methylvinylchlorosilane, vinyltrichlorosilane, and vinyltriethoxysilane (VTES).

Optionally, the free radical thermal initiator is one or more of azobisisobutyronitrile, azobisisoheptonitrile, dimethyl azobisisobutyrate, hydrogen peroxide, ammonium persulfate, potassium persulfate, benzoyl peroxide, tert-butyl benzoyl peroxide, methyl ethyl ketone peroxide, dibenzoyl peroxide, N,N-dimethylaniline, or dimethyl-β-propiothetin.

Optionally, in percentage by mass, the matrix includes:
69.4% of the methyl methacrylate,
6% of the butyl acrylate,
0% of the hydroxyethyl methacrylate,
13.6% of the isobornyl methacrylate,
10% of the dodecafluoroheptyl methacrylate,
0.7% of the dibenzoyl peroxide, and
0.7% of N,N-dimethyl-p-toluidine.

The present application further discloses a non-film-forming matrix for a photopolymer, which includes, in percentage by mass, 30-70% of a matrix and 30-70% of a solvent 1, where the matrix includes:
40-85% of methyl methacrylate,
0-50% of a low-Tg acrylic monomer,
0-20% of a cross-linked acrylic monomer,
5-20% of a rigid pendant group monomer,
4-20% of a fluorine-containing or silicon-containing acrylic monomer, and
0.5-5% of a free radical thermal initiator.

The present application further discloses a photopolymer film, which includes the above-mentioned photopolymer and two layers of protective films, where the two layers of protective films respectively cover both sides of the photopolymer.

The present application further discloses a photopolymer printing stock, which includes a printing stock and the above-mentioned photopolymer, where the photopolymer is cured onto the printing stock and carries a volume holographic grating.

Compared with the prior art, the photopolymer provided in an embodiment of the present application has beneficial effects as follows: by changing the brittleness of a photopolymer coating formulation to make it non-film-forming in the present application, the photopolymer can not only meet optical requirements, such as a high transmittance, a low refractive index, and a low haze, but also have higher Tg and lower adhesion to the protective films without sticking to the protective films; the protective films are removed without damaging the photopolymer during transfer printing; and the photopolymer itself is brittle and can be locally transfer printed by hot stamping, cold transfer printing, and the like in an embossing and blunt cutting manner using a die head.

### BRIEF DESCRIPTION OF THE DRAWINGS

The technical solutions of the present application are further described in detail below in conjunction with the accompanying drawings and embodiments. In the accompanying drawings:
FIG. 1 is a schematic diagram of fabrication of a volume holographic master plate in an embodiment of the present application;
FIG. 2 is a schematic diagram of a photopolymer and a positioning mark on a volume holographic master plate in an embodiment of the present application;
FIG. 3 is a schematic diagram of a photopolymer film in an embodiment of the present application;
FIG. 4 is a schematic diagram of coating of a photopolymer film in an embodiment of the present application;
FIG. 5 is a schematic diagram of replication of a volume holographic grating onto a photopolymer film via a volume holographic master plate in an embodiment of the present application;
FIG. 6 is a schematic diagram of a continuous photopolymer film replicated with volume holographic gratings and positioning marks in an embodiment of the present application;
FIG. 7 is a schematic diagram of a flow for further enhancing a volume holographic grating in an embodiment of the present application;
FIG. 8 is a schematic diagram of transfer printing of a photopolymer film onto a printing stock in an embodiment of the present application;
FIG. 9 is a physical image of a photopolymer film with a volume holographic pattern after exposure in an embodiment of the present application;

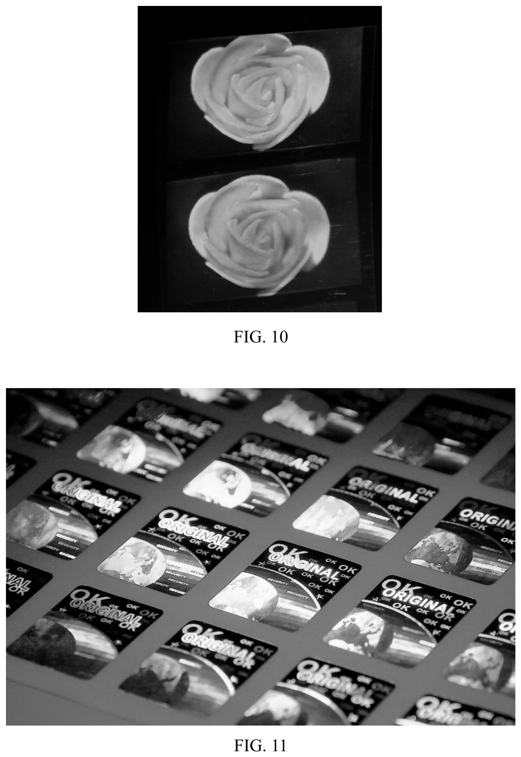

FIG. 10 is another physical image of a photopolymer film with a volume holographic pattern after exposure in an embodiment of the present application;
FIG. 11 is a physical image of a laser-molded holographic film currently available on the market;

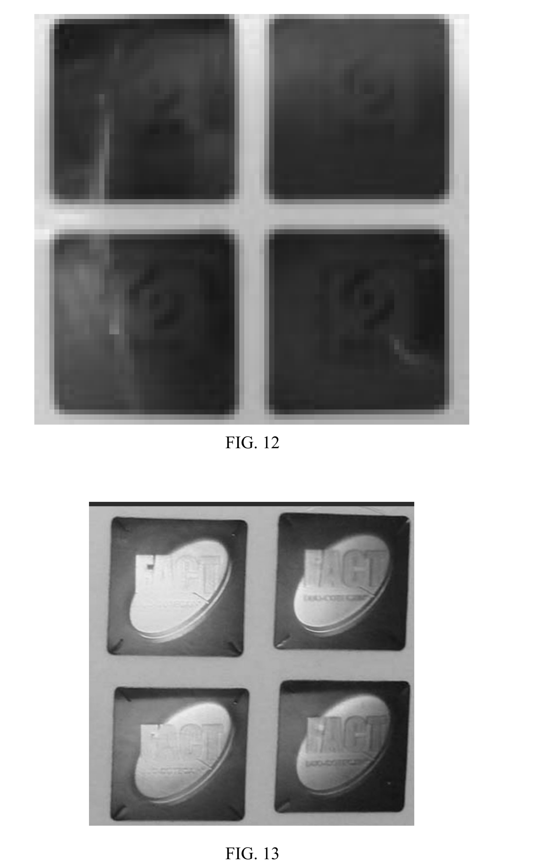

FIG. 12 is a physical image of a silver salt material film currently available on the market (observed under a non-point light source); and
FIG. 13 is a physical image of the silver salt material film currently available on the market (observed under a point light source).

### DESCRIPTION OF THE EMBODIMENTS

It should be noted that the embodiments and features in the embodiments of the present application may be combined with each other without a conflict. The preferred embodiments of the present application are described in detail now.

A photopolymer is usually exposed to visible light, a monochromatic visible laser is used as an exposure light source, a volume holographic grating is formed within the photopolymer, and refractive index modulation of the volume holographic grating depends on a refractive index difference between a photosensitive polymerized part and a matrix serving as a carrier. During fabrication of the photopolymer, its equipment cost is much lower than that of an array-type optical waveguide and a surface relief grating optical waveguide, and the maximum cost of the laser is only hundreds of thousands. The laser light source used for exposure has an extremely high speed, which is only a fraction of a second. Moreover, noncontact production has both higher production efficiency and yield than array-type optical waveguide and surface relief grating optical waveguide processes.

The photopolymer has a very thin coating and has a transmittance required to reach more than 85%, and the volume holographic grating is parallel to a coating surface and is deeply embedded in the photopolymer. Therefore, the situation of an uneven or discontinuous appearance cannot be observed by the naked eyes, making the photopolymer an excellent material for fabricating optical waveguide lenses. However, due to limitations of photopolymer sources and high requirements for optical parameters, a fabrication process for the volume holographic grating is not yet mature. Thus, it is currently difficult for the photopolymer to become a mainstream optical waveguide material, thereby greatly limiting the application of the photopolymer.

In a current fabrication process, a printing stock, such as an AR lens substrate, is coated with an unexposed photopolymer solution in a darkroom by screen printing, blade coating, spin coating, and other manners, then oven-dried, and covered with a protective film. Before use, it needs to be stored in a refrigerated environment at 4-8°C in a dark place, and meanwhile, it cannot be simply stacked and placed flat in order not to affect a soft and unexposed photopolymer coating. In a process used in the present application, a protective film is coated with an unexposed photopolymer solution, covered with another protective film for protection, then exposed to form a volume holographic grating within a photopolymer, and transfer printed by post-treatment onto a printing stock, such as an AR lens, a packaging material, and an anti-counterfeiting material.

In the first process of the above two processes, an unexposed photopolymer is formulated into the low-concentration photopolymer solution to ensure the dispersion uniformity and low migration difficulty of various components in a photochemical reaction, then coated, and oven-dried or air-dried to form a film. This unexposed material solution has a very low viscosity, flows easily during coating, and cannot maintain a required thickness due to a gravity impact when coated onto a curved surface. Thus, this process is generally used for a flat printing stock, such as a flat AR lens. Additionally, the flat AR lens has a large volume after direct coating, is not suitable for stacked storage before exposure, and has a refrigeration demand during storage, thus having higher requirements for a semi-finished product warehouse. During exposure and processing, since the flat AR lens is discontinuous, laser interference shooting has extremely high requirements for vibration, and loading and unloading actions on a production line generate vibration, a period of static platform time is required during production (the time waiting for all shooting actions to completely stop after the laser interference shooting is completed), resulting in relatively low production efficiency.

In the process used in the present application, the protective film is coated with an unexposed photopolymer, oven-dried, and then covered with another protective film to isolate oxygen and prevent oxygen inhibition of a photochemical reaction. Then, a coated photopolymer film with a sandwich structure is fed into an exposure optical path in a roll-to-roll manner, and a volume holographic grating structure designed on a volume holographic grating master plate is exposed onto the photopolymer by an interference method, thereby recording volume holographic image information onto the photopolymer film.

A photopolymer formulation generally includes two parts, including a photocuring system and a matrix. The photocuring system is induced to undergo a photocuring reaction at a bright fringe of a volume holographic grating to form a high-refractive-index volume holographic grating structure, which generates a refractive index difference, namely refractive index modulation, with the low-refractive-index matrix to achieve reflection and refraction of light within a fixed narrow wavelength range. However, in previous photopolymer formulations, the matrix is generally an ethylene-vinyl acetate copolymer (EVA) or a partially fluorine-substituted high polymer of the EVA. Their refractive indices are generally in a range of 1.42-1.45. These film-forming resins have high transparency and low refractive indices, thus being suitable to serve as optical materials. However, they have low brittleness and a lower glass transition temperature (Tg) of about 20-50°C. The photopolymer forms a film (namely, forms an integrated film layer) and adheres to the protective films after photocuring, and the protective films cannot be completely removed, so that local transfer of a coating and complete transfer printing are difficult to achieve, only a manner of fitting after die cutting can be adopted for use, and that is, the coating is transferred together with the protective films after die cutting with a sharp blade. Based on this, it is also very difficult to ensure smooth fitting for a curved surface. Due to this production method, the protective films need to be highly transparent and corrosion-resistant optical films, and commonly used films include PET (polyester) protective films and TAC (cellulose acetate) protective films. The PET protective films have high yield strength and low tensile strength, and are prone to wrinkles that cannot be smoothed out when fitted onto a curved surface with large curvature. The TAC protective films have poor shear resistance and low tensile strength, and are prone to breakage when applied to a curved surface. Additionally, since the protective films have a thickness of at least tens to hundreds of microns, the transmittance is also affected to a certain extent after fitting with the protective films.

An embodiment of the present application provides a method for preparing a photopolymer film, which includes the steps of:
S100: proportionally weighing methyl methacrylate, a low-Tg acrylic monomer, a cross-linked acrylic monomer, a rigid pendant group monomer, a fluorine-containing or silicon-containing acrylic monomer, and a free radical thermal initiator in percentage by mass to serve as a matrix, where in percentage by mass, the methyl methacrylate is 40-85%, the low-Tg acrylic monomer is 0-50%, the cross-linked acrylic monomer is 0-20%, the rigid pendant group monomer is 5-20%, the fluorine-containing or silicon-containing acrylic monomer is 4-20%, and the free radical thermal initiator is 0.5-5%;
S200: heating and refluxing the matrix in a solvent 1 for 1-8 hours to obtain a non-film-forming matrix, where in percentage by mass, the solvent 1 is 30-70%, and the matrix is 30-70%; and the solvent 1 herein may be butanone;
S300: proportionally weighing the non-film-forming matrix, a high-refractive-index monomer, a visible light trapping agent, and a photoinitiator to serve as a raw material I, where in percentage by mass, the non-film-forming matrix is 40-80%, the high-refractive-index monomer is 10-45%, the visible light trapping agent is 0.01-5%, and the photoinitiator is 1-10%;
S400: stirring and dissolving the raw material I in a solvent 2 to obtain a photopolymer solution, where the solvent 2 herein may be added at 15-25%, with a remainder being the raw material I; and the solvent 2 herein may be butanone, ethyl acetate, methanol, or dichloromethane;
S500: fabricating a volume holographic grating master plate with a positioning mark;
S600: coating the photopolymer solution onto a protective film and oven-drying to form a photopolymer coating, and covering the photopolymer coating with a protective film to obtain a photopolymer intermediate;
S700: replicating a volume holographic grating on the volume holographic grating master plate onto the photopolymer intermediate to obtain a photopolymer film with a volume holographic grating; and
S800: performing UV irradiation and heating on the photopolymer film.

In the method for preparing a photopolymer film of the present application, the non-film-forming matrix is used as a base material, where the non-film-forming matrix includes the methyl methacrylate, the low-Tg acrylic monomer, the cross-linked acrylic monomer, the rigid pendant group monomer, the fluorine-containing or silicon-containing acrylic monomer, and the free radical thermal initiator. Such photopolymer can not only meet optical requirements, such as a high transmittance, a low refractive index, and a low haze, but also have higher Tg and lower adhesion to the protective films without sticking to the protective films; the protective films are removed without damaging the photopolymer during transfer printing; and the photopolymer itself is brittle and can be locally transfer printed by hot stamping, cold transfer printing, and the like in an embossing and blunt cutting manner using a die head.

Specifically, in the preparation method of the present application, by changing the brittleness of a photopolymer coating formulation to make it non-film-forming during preparation (i.e., having high brittleness and being unable to form an integrated film layer and exist independently as a film, but needs to rely on another surface, such as a protective film, to become a thin layer structure), the photopolymer does not adhere to the protective films in the step S600. In terms of process, the photopolymer is coated onto the protective film, oven-dried, and covered with another protective film to obtain a rolled-up unexposed photopolymer, which is suitable for production on an assembly line. The difficulty and space of refrigerated storage of a semi-finished product are also reduced, thereby greatly reducing the production cost.

Specifically, in the steps S100 and S300, specific proportions, compositions, effects, and the like of various components are the same as corresponding contents described below, which are not described repeatedly herein.

In the step 200, the butanone solvent may be selected in an appropriate amount, for example, 30%, 35%, 40%, 45%, 50%, 55%, 60%, 65%, or 70%, and the matrix is 30%, 35%, 40%, 45%, 50%, 55%, 60%, 65%, or 70%; or for example, amounts shown in Table 1 below may also be used. A heating and reflux time may be 1 h, 1.5 h, 2 h, 2.5 h, 3 h, 3.5 h, 4 h, 4.5 h, 5 h, 5.5 h, 6 h, 6.5 h, 7 h, 7.5 h, or 8 h.

The obtained non-film-forming matrix is clear and transparent and has certain viscosity, which is used for subsequent formulation of the photopolymer, where the viscosity may be adjusted by adjusting the addition amount of the butanone solvent. In the subsequent processing step S600, the butanone solvent volatilizes during the oven-drying.

In the step S400, after being dissolved in the solvent, the raw material I is stored in a dark place at 0-4°C for later use. The viscosity of the photopolymer solution may be adjusted by adjusting the use amount of the solvent.

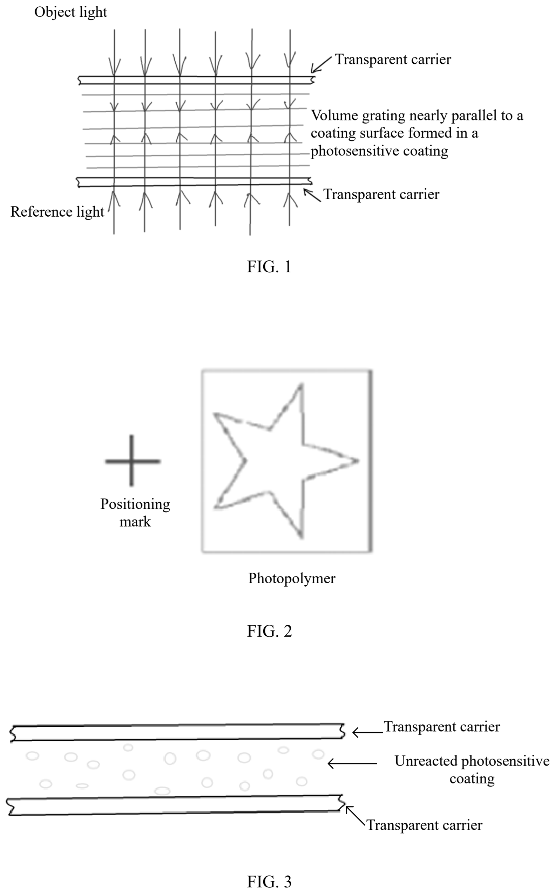

In the step 500, referring to FIGs. 1 and 2, when the volume holographic master plate of the photopolymer is fabricated, parameters, such as the angle and distribution of the grating, are designed first according to specific requirements of an optical lens or a holographic image, and then, an object light and a reference light enter from both sides of the photopolymer to form alternating bright and dark fringes nearly parallel to the coating surface within the photopolymer. Since an optical path respectively enters from both sides, a support for the photopolymer, namely the protective film, needs to be transparent (transparent carrier). A light source used is a visible laser light source. Since the reference light and the object light have large incident angles, a reconstructed viewing angle is also large, the holographic image can exhibit a stronger and more realistic stereoscopic effect, and a fabricated and obtained stereoscopic image has a pure and clear colour.

Since the volume holographic grating (volume grating) is deeply embedded in the photopolymer coating and does not form grooves on the coating surface, it is not required to perform elution treatment on the master plate, only chemical development and fixation treatment needs to be performed on the formed grating, and a new high molecular polymer formed at the grating and a high molecular polymer in the matrix having different refractive indices generate a refractive index difference, thus achieving refractive index modulation and enabling reading and writing. The refractive index modulation is a basis for information storage.

Methods for processing the volume holographic grating include wet processing and dry processing. The wet processing usually includes formulating a suitable development and fixation solution to enlarge and enhance the internal grating. The dry processing usually includes UV light irradiation and heating, which also promotes the occurrence of an internal chemical reaction to fix and enhance the internal grating. During the design and fabrication of the master plate, the positioning mark on the master plate and the required volume holographic grating are replicated onto the photopolymer one to one in an allelic manner. Specifically, the photopolymer solution can be coated onto a rolled-up protective film to obtain a rolled-up photopolymer intermediate, which facilitates continuous processing.

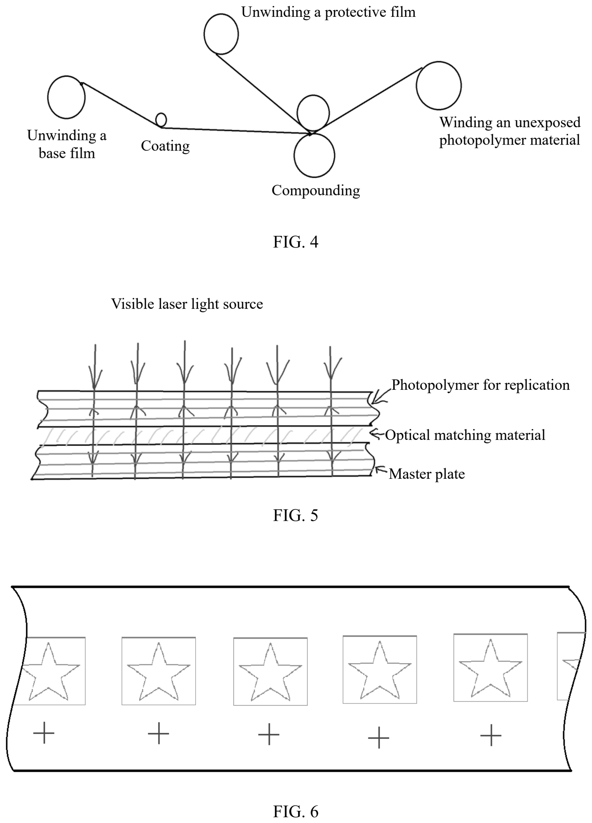

In the step S600, referring to FIGs. 3 and 4, the photopolymer solution is a semi-fluid viscous coating before undergoing a photocuring reaction, and thus needs to be compounded with a layer of protective film (transparent carrier) immediately after complete coating, and that is to say, winding can be performed with protective layers (transparent carriers) on both upper and lower sides. Furthermore, the photopolymer undergoes a free radical reaction with a strong oxygen inhibition effect during the photocuring, the chemical reaction can occur effectively with the protective films on upper and lower sides, and the upper and lower protective films have the effect of isolating oxygen.

Specifically, the unexposed photopolymer solution may be coated onto a transparent substrate, such as a transparent protective film (transparent carrier), in a light-shielded environment and oven-dried to form a thin coating with a thickness ranging from several microns to several hundred microns. According to different specific production products, glass, a transparent resin plate, a transparent resin sheet, or another layer of transparent film may be selected for coverage to form a sandwich structure. During preferred production, first in a darkroom, the unexposed photopolymer solution is entirely coated onto a substrate by a blade coating device, and the substrate selected mainly includes a high-transparency PET protective film and a TAC protective film. Entire roll coating is achieved on a roll-to-roll blade coater. After the coating, the substrate surface is fully covered with the photopolymer solution with a wet coating thickness of 20-2,000 microns. After the drying, the substrate surface is fully covered with an unexposed photopolymer adhesive layer with a dry coating thickness of 2-500 microns, mainly about 10 microns, and is then wound or stacked and stored for later use after compounding with a layer of protective film.

In the step 700, as shown in FIGs. 5 and 6, when the volume holographic grating and its positioning mark on the master plate are replicated onto a photopolymer bulk material, the reference light needs to transmit through the replicated unexposed photopolymer to make the reference light reflected on the master plate, and the object light formed after reflection and the reference light interfere within the unexposed photopolymer to form a replicated volume holographic grating.

During the replication, a visible laser light source compatible with the master plate is still used. A replication principle still involves forming bright and dark fringes by light interference, and inducing photochemical reactions at the bright fringes to obtain the volume holographic grating that is deeply embedded in the photopolymer and is parallel to the coating surface.

Since the laser light source needs to transmit a photosensitive material to reach the master plate during the replication, upper and lower supports (transparent carriers) of the photopolymer need to have high transparency. This determines that the supports of the photopolymer cannot be materials coated with a release agent. Because an opaque component of the release agent will generate great noise, a blurry and scattered holographic image is caused after the replication, the quality is extremely poor, and the image even cannot be clearly identified.

In the step S800, referring to FIG. 6, after the volume holographic grating in the photopolymer is exposed and replicated with the master plate, post-treatment processes, such as UV irradiation for fixation, heating for strengthening, and UV irradiation to terminate a reaction, need to be performed, thereby stabilizing the volume holographic grating.

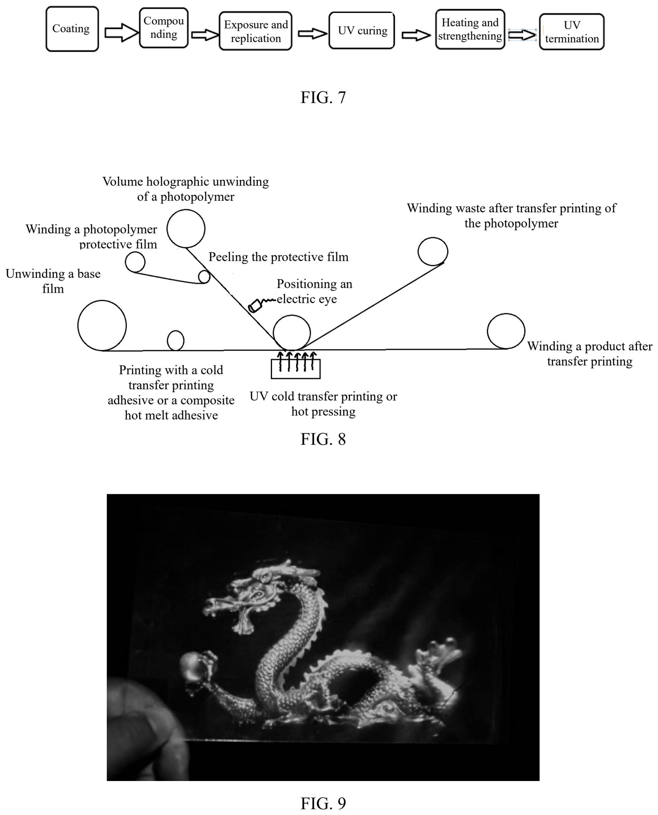

Referring to FIG. 8, the protective films of the photopolymer films may be in a roll form, such as rolled-up photopolymer films. A printing stock (sheet or continuous substrate, etc.) is coated with a cold stamping adhesive or a composite hot melt adhesive to position and transfer the photopolymer bulk material with the volume holographic grating in the photopolymer film. Since the photopolymer with the volume holographic grating has the protective films on the upper and lower sides, one layer of protective film is first peeled off during use. The printing stock is printed or coated with a cold transfer printing adhesive or a composite hot melt adhesive after the transfer printing. Meanwhile, the positioning mark replicated together with the volume holographic grating is read. The brittle photopolymer bulk material is cut by blunt cutting of edges using an embossing template of a device, which can obtain a photopolymer bulk material with neatly shaped edges. After the photopolymer bulk material is transfer printed onto the printing stock, the cold transfer printing adhesive is cured by irradiation under a UV light source, or the hot melt adhesive is cured by cooling, thereby firmly transferring the photopolymer bulk material onto the printing stock. Meanwhile, the other layer of protective film is peeled off, thereby completing the transfer of the photopolymer onto the printing stock and obtaining the photopolymer without the upper and lower protective films. Thus, such the printing stock has a small thickness and a small concavo-convex sense since the photopolymer thereon is obtained by transfer printing and completely lacks the protective films, and meanwhile, has a clear and stereoscopic holographic image.

An embodiment of the present application provides a photopolymer for preparation in the above-mentioned method for preparing a photopolymer film. In percentage by mass, the photopolymer includes 50-80% of a matrix and 20-50% of a compound base. The matrix may be 50%, 55%, 60%, 65%, 70%, 75%, or 80%, and the compound base may be 20%, 25%, 30%, 35%, 40%, 45%, or 50%. Preferably, the matrix is 60-75%, and the compound base is 25-40%. More preferably, the matrix is 66.9%, and the compound base is 33.1%.

The compound base includes 70-90% of a high-refractive-index monomer, 0.1-10% of a visible light trapping agent, and 9-20% of a photoinitiator.

Specifically, in percentage by mass, the proportion of the high-refractive-index monomer in the compound base may be 70%, 72%, 75%, 78%, 80%, 83%, 85%, 87%, or 90%. The proportion of the visible light trapping agent in the compound base may be 0.1%, 0.5%, 1%, 1.5%, 2%, 3%, 4%, 4.5%, 5%, 6%, 7%, 8%, 9%, or 10%. The proportion of the photoinitiator in the compound base may be 9%, 10%, 11%, 12%, 13%, 14%, 15%, 16%, 17%, 18%, 19%, or 20%.

In percentage by mass, the matrix includes 40-85% of methyl methacrylate, 0-50% of a low-Tg acrylic monomer, 0-20% of a cross-linked acrylic monomer, 5-20% of a rigid pendant group monomer, 4-20% of a fluorine-containing or silicon-containing acrylic monomer, and 0.5-5% of a free radical thermal initiator. Specifically, in percentage by mass, the proportion of the methyl methacrylate in the matrix may be 40%, 45%, 50%, 55%, 60%, 65%, 70%, 75%, 80%, or 85%; the proportion of the low-Tg acrylic monomer in the matrix may be 0%, 5%, 10%, 15%, 20%, 25%, 30%, 35%, 40%, 45%, or 50%; the proportion of the cross-linked acrylic monomer in the matrix may be 0%, 5%, 10%, 15%, or 20%; the proportion of the rigid pendant group monomer in the matrix may be 5%, 8%, 10%, 12%, 15%, 17%, or 20%; the proportion of the fluorine-containing or silicon-containing acrylic monomer in the matrix may be 4%, 8%, 10%, 12%, 15%, 17%, or 20%; and the proportion of the free radical thermal initiator in the matrix may be 0.5%, 1%, 1.5%, 2%, 2.5%, 3%, 3.5%, 4%, 4.5%, or 5%.

In general, during the preparation, the non-film-forming matrix includes 30-70% of the matrix and 30-70% of the solvent 1. After the photopolymer solution is prepared with the non-film-forming matrix, the solvent 1 and the solvent 2 are present, i.e., the photopolymer solution includes 15-25% of the solvent 2 and a remainder of the non-film-forming matrix and the compound base. The non-film-forming matrix includes the solvent 1 and the matrix, and specific components of the matrix and the compound base are as described above and are not described repeatedly herein. After the photopolymer solution is oven-dried, the solvent 1 and the solvent 2 volatilize, and a film-like photopolymer is obtained. At this time, the photopolymer includes 50-80% of the matrix and 20-50% of the compound base.

The photopolymer of the present application uses the non-film-forming matrix as a base material, where the non-film-forming matrix includes 30-70% of the matrix and 30-70% of the solvent 1. During the preparation, the solvent in the non-film-forming matrix volatilizes, leaving only the matrix. The matrix includes the methyl methacrylate, the low-Tg acrylic monomer, the cross-linked acrylic monomer, the rigid pendant group monomer, the fluorine-containing or silicon-containing acrylic monomer, and the free radical thermal initiator. Such photopolymer can not only meet optical requirements, such as a high transmittance, a low refractive index, and a low haze, but also have higher Tg and lower adhesion to the protective films without sticking to the protective films; the protective films are removed without damaging the photopolymer during transfer printing; and the photopolymer itself is brittle and can be locally transfer printed by hot stamping, cold transfer printing, and the like in an embossing and blunt cutting manner using a die head.

Specifically, by changing the brittleness of a photopolymer coating formulation to make it become non-film-forming (i.e., does not form an integrated film layer) in the present application, the photopolymer does not adhere to the protective films. In terms of process, the photopolymer is coated onto the protective film, oven-dried, and covered with another protective film to obtain a rolled-up unexposed photopolymer, which is suitable for production on an assembly line. The difficulty and space of refrigerated storage of a semi-finished product are also reduced, thereby greatly reducing the production cost. Then, the volume holographic grating master plate with the volume holographic grating is fabricated and designed. On a continuous device, the volume holographic grating of the volume holographic grating master plate is replicated onto a photopolymer roll material using a single-beam laser, followed by post-processing. Since the single-beam laser does not have strict requirements for vibration, a static platform time is not required, which can achieve continuous production and greatly improve production efficiency. After dry post-processing and curing (heating and UV curing), the protective film on one side can be peeled off, a required part of the photopolymer with the volume holographic grating structure can be locally transfer printed by a die head with a concave-convex surface or a flat die head in UV cold transfer printing, thermal stamping, and other manners, and meanwhile, the other protective film is peeled off. It not only solves the problem of fabricating the volume holographic grating of the photopolymer on a curved surface, but also does not require the protective films, thereby improving the transmittance.

The non-film-forming matrix of the present application is based on the characteristic of high transparency of acrylate polymers, with the high-Tg methyl methacrylate as a main part. Small amounts of other monomers with rigid pendant groups, such as the isobornyl methacrylate, the dicyclopentadiene and a derivative thereof, and the adamantyl acrylate, are added into the formulation. The rigid monomers with large pendant groups can reduce the rotational mobility of molecular chains and freeze the molecular chains. The synthesized non-film-forming matrix has greatly increased brittleness and is prone to breakage, thus facilitating cutting and separation by a blunt object. During transfer printing, local transfer printing, and die cutting, edges can be cut very neatly with a blunt object.

Since the rigid pendant group monomer with a cyclic pendant group and its high polymers have relatively high refractive indices, to lower the refractive index of the non-film-forming matrix and further reduce the adhesion between the non-film-forming matrix and the protective films for better peeling, a part of the fluorine-containing or silicon-containing acrylic monomer needs to be added. Since optical materials have high requirements for transmittance, protective films that have sufficient strength and can support roll coating and oven-drying on the market can only be selected from PET protective films or TAC protective films without release agent coatings. According to protective films with release agent coatings, the release agent coatings are generally silicone oil and fluorides. On the one hand, due to low adhesion, the release agent coatings easily fall onto the photopolymer, resulting in black spot defects. On the other hand, such protective films with release agent coatings have lower transmittance, usually only about 80%. Meanwhile, the release agent coatings also lead to a higher haze, thereby bringing great noise during optical shooting and making a volume holographic image blurry.

Specifically, the present application uses the high-Tg acrylic monomer, namely the methyl methacrylate (MMA), as a main part. The polymethyl methacrylate (PMMA) obtained after cross-linking and polymerization of the methyl methacrylate has high transmittance (approximately 92%) and high Tg (approximately 105°C), as well as high brittleness and low impact resistance, making it suitable to serve as a base material for a brittle photopolymer. In the present application, the methyl methacrylate (MMA) is used as a main component, a small amount of the rigid pendant group monomer with a large cyclic group is added to further increase the brittleness of the photopolymer, and then the fluorine-containing or silicon-containing acrylic monomer is added to reduce the adhesion between the photopolymer and the protective films, thus facilitating complete removal of the protective films. In the present application, oily free radicals of the acrylic monomers are polymerized with butanone as a solvent, and a polymerization reaction is initiated with the free radical thermal initiator.

Specifically, in percentage by mass, the proportion of the methyl methacrylate in the matrix may be 40%, 45%, 50%, 55%, 60%, 65%, 70%, 75%, 80%, or 85%; the proportion of the low-Tg acrylic monomer in the matrix may be 0%, 5%, 10%, 15%, 20%, 25%, 30%, 35%, 40%, 45%, or 50%; the proportion of the cross-linked acrylic monomer in the matrix may be 0%, 5%, 10%, 15%, or 20%; the proportion of the rigid pendant group monomer in the matrix may be 5%, 8%, 10%, 12%, 15%, 17%, or 20%; the proportion of the fluorine-containing or silicon-containing acrylic monomer in the matrix may be 4%, 8%, 10%, 12%, 15%, 17%, or 20%; and the proportion of the free radical thermal initiator in the matrix may be 0.5%, 1%, 1.5%, 2%, 2.5%, 3%, 3.5%, 4%, 4.5%, or 5%.

Specifically, in percentage by mass, the matrix includes 69.4% of the methyl methacrylate, 6% of the butyl acrylate, 0% of the hydroxyethyl methacrylate, 13.6% of the isobornyl methacrylate, 10% of the dodecafluoroheptyl methacrylate, 0.7% of the dibenzoyl peroxide, and 0.7% of N,N-dimethyl-p-toluidine. At these component proportions, the non-film-forming matrix has an elongation at break of only 8.02% and a peel strength of only 0.23 N/25 mm, and the correspondingly fabricated photopolymer has high brittleness and is prone to fracture, thus facilitating separation and cutting by a blunt object without adhesion to the protective films.

The low-Tg acrylic monomer is one or more of ethyl acrylate (EA), butyl acrylate (BA), 2-ethylhexyl acrylate (2-EHA), lauryl acrylate, and dodecyl acrylate. When the low-Tg acrylic monomer has a longer carbon chain, the monomer has greater flexibility, with the order of flexibility as follows: ethyl acrylate (EA) < butyl acrylate (BA) < 2-ethylhexyl acrylate (2-EHA) < lauryl acrylate < dodecyl acrylate. Due to greater flexibility and a higher addition amount, the non-film-forming matrix has lower brittleness, stronger adhesion to the protective films, and lower glass transition temperature. Therefore, depending on different protective films, one or more of these monomers may be selected or not be selected, so that the photopolymer can not only appropriately adhere to the protective films to achieve the effect of being covered and protected by the protective films, but also do not adhere to the protective films.

The cross-linked acrylic monomer is one or more of hydroxyethyl acrylate (HEA), hydroxyethyl methacrylate (HEMA), acrylamide (AAM), N-methylol acrylamide (NMA), diacetone acrylamide (DAAM), acetoacetoxyethyl methacrylate (AAEM), glycidyl methacrylate (GMA), and dimethylaminoethyl methacrylate (DMAEMA). These cross-linked acrylic monomers contain functional monomers with groups such as amido, amino, and an epoxy group that provide a cross-linking function, and may be selected according to requirements of different products. The presence of certain cross-linking groups can increase the hardness and weather resistance (resistance to high and low temperatures, light, ultraviolet, oxidation, water, solvents, etc.) of the non-film-forming matrix, decrease the brittleness, improve the temperature resistance, and improve the adhesion to the protective films. These cross-linked acrylic monomers play a regulation role and may be added or not added according to different protective films and use environments.

The rigid pendant group monomer is one or more of isobornyl methacrylate (IBOA), dicyclopentadiene and a derivative thereof, and adamantyl acrylate, where the dicyclopentadiene is a difunctional monomer. The adamantyl acrylate may be specifically adamantyl methacrylate. Structural formulas of the isobornyl methacrylate (IBOA), the dicyclopentadiene, and the adamantyl methacrylate are as follows:

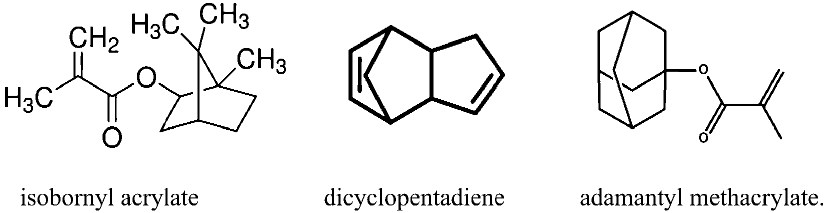

The fluorine-containing acrylic monomer is one or more of trifluoroethyl acrylate (TFEA), trifluoroethyl methacrylate (TFEMA), hexafluorobutyl acrylate (HFBA), and dodecafluoroheptyl methacrylate (DFMA). The silicon-containing acrylic monomer is one or more of methylvinylchlorosilane, vinyltrichlorosilane, and vinyltriethoxysilane (VTES). These silicon-containing acrylic monomers are organosilicone monomers with vinyl. The fluorine-containing or silicon-containing acrylic monomer reduces the adhesion between the non-film-forming matrix and the protective films, thereby facilitating complete removal of the protective films.

The thermal free radical initiator is one or more of azobisisobutyronitrile, azobisisoheptonitrile, dimethyl azobisisobutyrate, hydrogen peroxide, ammonium persulfate, potassium persulfate, benzoyl peroxide, tert-butyl benzoyl peroxide, and methyl ethyl ketone peroxide, where one or more of them may be selected according to demands.

Specifically, in the present application, dibenzoyl peroxide (BPO) and N,N-dimethylaniline (namely dimethylaniline, DMA) or dimethyl-β-propiothetine (DMPT) are preferred, which can be used for room-temperature polymerization of the methyl methacrylate and other monomers. Specifically, a BPO-DMPT initiation system has a higher decomposition rate and a higher polymerization rate than a BPO-DMA initiation system, and when the DMPT is adopted, a polymer has better colour and lustre stability than that using the DMA.

During the preparation of the non-film-forming matrix, various components of the matrix are added into the butanone solvent, heated, and refluxed for 1-8 hours to obtain a clear and transparent non-film-forming matrix solution with certain viscosity, and the non-film-forming matrix solution can be directly used for formulating the photopolymer. During subsequent preparation process, the butanone solvent volatilizes.

The high-refractive-index monomer may be one or more of 9,9-bis[3-phenyl-4-(β-hydroxyethoxy)phenyl]fluorene, phenolic ethoxy acrylate, ethoxy bisphenol fluorene diacrylate, vinyl carbazole, and a sulfur-containing acrylate monomer. The visible light trapping agent may be an acridine dye (460 nm), a xanthene dye (565 nm), or a thiazine dye (668 nm), such as methylene blue, erythrosin b, eosin, azure I, etc.

The photoinitiator may be diaryl titanocene such as 6, bis(2,6-difluoro-3-pyrrolylphenyl)titanocene (GR-FMT, 784), an arylferrocene salt such as η6-isopropylbenzene(II) hexafluorophosphate (i-261), an ultraviolet initiator such as bisimidazole, a borate, etc.

The above high-refractive-index monomer, the visible light trapping agent, and the photoinitiator are added into the above-mentioned non-film-forming matrix solution containing the butanone solvent. Then, an appropriate amount of the solvent 2, such as the butanone, the ethyl acetate, the methanol, or the dichloromethane, is added, for example, the solvent 2 is added at 15-25%, and a remainder includes the non-film-forming matrix and the compound base. The concentration is adjusted, all the components are stirred at room temperature in a darkroom until they are completely dissolved to obtain a photopolymer solution, which is stored in the dark at 0-4°C for later use. Stirring in the darkroom and storage in the dark can prevent external original light from initiating a polymerization reaction. During use, the photopolymer solution is coated onto a carrier, such as a glass plate or a protective film, covered with another protective film, and exposed to a 532 nm green laser, thereby achieving a maximum diffraction efficiency of more than 85%.

The present application further discloses a non-film-forming matrix for the above-mentioned photopolymer, which includes, in percentage by mass, 30-70% of a matrix and 30-70% of a solvent 1. The solvent 1 may be 30%, 35%, 40%, 45%, 50%, 55%, 60%, 65%, or 70%, and the matrix may be 30%, 35%, 40%, 45%, 50%, 55%, 60%, 65%, or 70%. The matrix includes:
40-85% of methyl methacrylate,
0-50% of a low-Tg acrylic monomer,
0-20% of a cross-linked acrylic monomer,
5-20% of a rigid pendant group monomer,
4-20% of a fluorine-containing or silicon-containing acrylic monomer, and
0.5-5% of a free radical thermal initiator.

The proportion of the methyl methacrylate in the matrix may be 40%, 45%, 50%, 55%, 60%, 65%, 70%, 75%, 80%, or 85%; the proportion of the low-Tg acrylic monomer in the matrix may be 0%, 5%, 10%, 15%, 20%, 25%, 30%, 35%, 40%, 45%, or 50%; the proportion of the cross-linked acrylic monomer in the matrix may be 0%, 5%, 10%, 15%, or 20%; the proportion of the rigid pendant group monomer in the matrix may be 5%, 8%, 10%, 12%, 15%, 17%, or 20%; the proportion of the fluorine-containing or silicon-containing acrylic monomer in the matrix may be 4%, 8%, 10%, 12%, 15%, 17%, or 20%; and the proportion of the free radical thermal initiator in the matrix may be 0.5%, 1%, 1.5%, 2%, 2.5%, 3%, 3.5%, 4%, 4.5%, or 5%.

The matrix is the same as the matrix in the above-mentioned photopolymer, with the same component composition, specific types of components, and action effects as above, which are not described repeatedly herein.

The present application further discloses a photopolymer film, which is prepared by the above-mentioned method for preparing a photopolymer film, and includes the above-mentioned photopolymer and two layers of protective films, where the two layers of protective films respectively cover both sides of the photopolymer.

During preparation of the photopolymer film, a volume holographic grating master plate with a positioning mark is first designed and fabricated, where the volume holographic grating master plate has required volume holographic image information.

An unexposed photopolymer solution is coated onto a transparent protective film using a roll-to-roll blade coater in a light-shielded environment, dried to form a thin coating with a thickness ranging from a few micrometers to several hundred micrometers, and then covered with another layer of transparent protective film to form a sandwich structure. The protective films are preferably high-transparency PET protective films and TAC protective films. Certainly, glass, transparent resin plates, transparent resin sheets, etc., may also be used as substitutes for the protective films, or in combination with the protective films.

In the present application, with the PET protective films serving as carriers as an example, the photopolymer solution is coated onto the PET protective film, dried, then covered with another layer of PET protective film, and wound into a roll. During exposure and replication, the rolled-up photopolymer film is continuously treated with a single-beam laser to replicate a volume holographic grating on the volume holographic grating master plate onto the photopolymer film. During the replication of the volume holographic grating onto the photopolymer, a reference light needs to transmit through the unexposed photopolymer during the replication to be reflected on the volume holographic grating master plate, and an object light formed by the reflection interferes with the reference light within the photopolymer to form a replicated volume holographic grating within the photopolymer. During the replication, a visible laser light source compatible with the volume holographic grating master plate is still used. A replication principle still involves forming bright and dark fringes by light interference, and inducing photochemical reactions at the bright fringes to form the volume holographic grating that is deeply embedded in the photopolymer and is parallel to a coating surface.

Since the laser light source needs to transmit through the photopolymer to reach the volume holographic grating master plate during the replication, both the upper and lower carriers of the photopolymer need to have high transparency. This determines that the carriers of the photopolymer cannot be materials coated with a release agent. As previously mentioned, because an opaque part of the release agent will generate great noise, a blurry and scattered holographic image after the replication is caused, the holographic image quality is extremely poor, and the image even cannot be clearly identified. The photopolymer of the present application can avoid adhesion to the protective films without using the release agent, thereby preventing interference from the release agent during the replication of the volume holographic grating.

After the photopolymer is compounded with the volume holographic grating master plate, exposed, and replicated, post-treatment processes, such as UV irradiation for fixation, heating for strengthening, and UV irradiation to terminate a reaction, need to be performed. After post-treatment, a replicated product of a holographic image of the volume holographic grating hologram with the upper and lower protective films and the photopolymer sandwiched therebetween, namely the photopolymer film, is obtained.

A comparison between the photopolymer film of the present application and finished products of other volume holographic processes currently available on the market is shown in the following table.

| | Photopolymer film | Laser-molded holographic film | Silver salt material film |
|---|---|---|---|
| Stereoscopic effect | Extremely strong as observed under natural light | Very weak | Strong, but usually requires observation under a point light source, preferably observation under a laser light source |
| Transparency | Completely transparent in a non-image part | Requires plating with zinc sulfide and has slightly lower transparency | Heavy colour in a non-image part, with low transparency |
| Colour | Bright and vivid single colour, with a diffraction efficiency of above 95% and an entire image presenting a clear feeling | Rarely has a single colour, and is generally a rainbow colour or a light colour | Single colour but not bright, with a gray-black surface and a diffraction efficiency of usually approximately 30% |
| Substrate | May be transparent, with black and red substrates providing optimal comparison effects for green laser trademarks | May be transparent, usually requires plating with aluminum, and requires a metal mirror surface to achieve an optimal effect | Requires a black substrate to highlight an image with high contrast |
| Application manner | Compounding, labelling with a self-adhesive, or transfer | Compounding, thermal transfer printing, or labelling with a self-adhesive | Labelling with a self-adhesive |
| Stability | Sunlight resistance, ultraviolet aging resistance, heat resistance, cold resistance, water resistance, high stability, and no discolouration | Poor sunlight resistance and stability, with fading, yellowing, and fragmentation after long-term exposure to sunlight | Poor water and moisture resistance, with easy mildewing and discolouration when exposed to moisture, thus damaging a coating; and not suitable for long-term storage of alcohols, thus affecting secondary transactions |
| Technical difficulty | High | Low, essentially with no technical barriers | Medium |
| Example | As shown in FIGs. 9 and 10, the stereoscopic effect is extremely strong and does not require observation under a point light source or a laser | As shown in FIG. 11, the stereoscopic effect is very weak | As shown in FIGs. 12 and 13, the stereoscopic effect is strong, but usually requires observation under a point light source, preferably observation under a laser light source; and according to observation under a non-point light source (natural light) as shown in FIG. 12, the stereoscopic effect is extremely poor |

The present application further discloses a photopolymer printing stock, which includes the above-mentioned photopolymer, where the photopolymer is cured onto a printing stock. When applying the photopolymer film, one layer of protective film is first peeled off, a sheet or continuous printing stock is coated with a cold stamping adhesive or a composite hot melt adhesive, the positioning mark shot and fabricated together with the volume holographic grating on the photopolymer is simultaneously read, and the brittle photopolymer is cut by blunt cutting of edges using an embossing template to obtain neatly shaped edges. At this time, after irradiation with a UV light source to cure a UV cold transfer printing adhesive, or cooling to cure a hot melt adhesive, the photopolymer is firmly transfer printed onto the printing stock. During the transfer printing, the other layer of protective film is peeled off synchronously, which can obtain the photopolymer printing stock without the upper and lower protective films.

The printing stock may include an AR lens, an AR-HUD display screen, a transparent display screen, a projection-type transparent HUD display screen, an AR smart helmet display mask, a security camera AR display lens, an airborne sight display screen, an individual sight, a film-type lens, and other transparent and displayable screens, and may also include various packaging materials and anti-counterfeiting materials, etc.

The technical solutions of the present application are described below through specific examples and comparative examples of the non-film-forming matrix.

### Examples 1-3

In Examples 1-3, use amounts of various components of non-film-forming matrices listed in Table 1 were respectively added into a flask and refluxed under heat preservation at 110°C for 3.5 h, and non-film-forming matrix solutions were taken out, air-dried and bonded on a 25 mm test specimen, and tested by a tensile tester to obtain their elongation at break and 90-degree peel strength to identify their brittleness and peelability. Results are shown in Table 1.

### Comparative Example

In this comparative example, 50 g of a commercially available EVA resin (LG Chem, ES28005) was selected and added into a flask, 50 g of butanone was added, the mixture was refluxed under heat preservation at 110°C for 3.5 h, and a non-film-forming matrix solution was taken out, air-dried and bonded on a 25 mm test specimen, and tested by a tensile tester to obtain its elongation at break and 90-degree peel strength to identify its brittleness and peelability. Results are shown in Table 1.

**Table 1**

| Component | Example 1 | Example 2 | Example 3 | Comparativ e Example 1 |
|---|---|---|---|---|
| Methyl methacrylate | 34.7 g | 36.7 g | 38.5 g | / |
| Butyl acrylate | 3 g | 3 g | 3 g | / |
| Hydroxyethyl methacrylate | 0 g | 3g | 3g | / |
| Isobornyl methacrylate | 6.8 g | 6.8 g | 0 | / |
| Dodecafluoroheptyl methacrylate | 5 g | 0 g | 5 g | / |
| Dibenzoyl peroxide | 0.35 g | 0.35 g | 0.35 g | / |
| N,N-dimethyl-p-toluidine | 0.15 g | 0.15 g | 0.15 g | / |
| Butanone | 50 g | 50 g | 50 g | / |
| Elongation at break | 8.02% | 4.55% | 136% | 800% |
| Peel strength | 0.23 N/25 mm | 7.3 N/25 mm | 1.77 N/25 mm | 10 N/25 mm |

Further, 50 g of the non-film-forming matrices prepared in Examples 1-3 above were respectively weighed, 3 g of phenolic ethoxy acrylate, 7.54 g of vinyl carbazole, 1.8 g of bis(2,6-difluoro-3-pyrrolylphenyl)titanocene (GR-FMT, 784), 0.028 g of erythrosin b, and 28 g of butanone were added respectively, and the mixtures were stirred and dissolved at room temperature, then coated onto glass plates or protective films, covered with protective films, and exposed to a 532 nm green laser. The maximum diffraction efficiency can reach more than 85%.

It should be understood that the above embodiments are provided only to describe the technical solutions of the present application, and are not intended to limit the present application. For those skilled in the art, modifications to the technical solution described in the above embodiments, or equivalent substitutions of some technical features therein, may be made, and all these modifications and substitutions shall fall within the scope of protection defined by the appended claims of the present application.

## Claims

1. A method for preparing a photopolymer film, **characterized by** comprising the steps of:
proportionally weighing methyl methacrylate, a low-Tg acrylic monomer, a cross-linked acrylic monomer, a rigid pendant group monomer, a fluorine-containing or silicon-containing acrylic monomer, and a free radical thermal initiator in percentage by mass to serve as a matrix, wherein in percentage by mass, the methyl methacrylate is 40-85%, the low-Tg acrylic monomer is 0-50%, the cross-linked acrylic monomer is 0-20%, the rigid pendant group monomer is 5-20%, the fluorine-containing or silicon-containing acrylic monomer is 4-20%, and the free radical thermal initiator is 0.5-5%;
heating and refluxing the matrix in a solvent 1 for 1-8 hours to obtain a non-film-forming matrix;
proportionally weighing the non-film-forming matrix, a high-refractive-index monomer, a visible light trapping agent, and a photoinitiator to serve as a raw material I, wherein in percentage by mass, the non-film-forming matrix is 40-80%, the high-refractive-index monomer is 10-45%, the visible light trapping agent is 0.01-5%, and the photoinitiator is 1-10%;
stirring and dissolving the raw material I in a solvent 2 to obtain a photopolymer solution;
fabricating a volume holographic grating master plate with a positioning mark;
coating the photopolymer solution onto a protective film and oven-drying to form a photopolymer coating, and covering the photopolymer coating with a protective film to obtain a photopolymer intermediate;
replicating a volume holographic grating on the volume holographic grating master plate onto the photopolymer intermediate to obtain a photopolymer film with a volume holographic grating; and
performing ultraviolet (UV) irradiation and heating on the photopolymer film.

2. A photopolymer, **characterized by** comprising, in percentage by mass, 50-80% of a matrix and 20-50% of a compound base; wherein the compound base comprises:
70-90% of a high-refractive-index monomer,
0.1-10% of a visible light trapping agent, and
9-20% of a photoinitiator; and
wherein in percentage by mass, the matrix comprises:
40-85% of methyl methacrylate,
0-50% of a low-Tg acrylic monomer,
0-20% of a cross-linked acrylic monomer,
5-20% of a rigid pendant group monomer,
4-20% of a fluorine-containing or silicon-containing acrylic monomer, and
0.5-5% of a free radical thermal initiator.

3. The photopolymer according to claim 2, **characterized in that** the low-Tg acrylic monomer is one or more of ethyl acrylate (EA), butyl acrylate (BA), 2-ethylhexyl acrylate (2-EHA), lauryl acrylate, and dodecyl acrylate.

4. The photopolymer according to claim 3, **characterized in that** the cross-linked acrylic monomer is one or more of hydroxyethyl acrylate (HEA), hydroxyethyl methacrylate (HEMA), acrylamide (AAM), N-methylol acrylamide (NMA), diacetone acrylamide (DAAM), acetoacetoxyethyl methacrylate (AAEM), glycidyl methacrylate (GMA), and dimethylaminoethyl methacrylate (DMAEMA); and/or
the rigid pendant group monomer is one or more of isobornyl methacrylate (IBOA), dicyclopentadiene and a derivative thereof, and adamantyl acrylate.

5. The photopolymer according to claim 4, **characterized in that** the fluorine-containing acrylic monomer is one or more of trifluoroethyl acrylate (TFEA), trifluoroethyl methacrylate (TFEMA), hexafluorobutyl acrylate (HFBA), and dodecafluoroheptyl methacrylate (DFMA); and
the silicon-containing acrylic monomer is one or more of methylvinylchlorosilane, vinyltrichlorosilane, and vinyltriethoxysilane (VTES).

6. The photopolymer according to claim 5, **characterized in that** the free radical thermal initiator is one or more of azobisisobutyronitrile, azobisisoheptonitrile, dimethyl azobisisobutyrate, hydrogen peroxide, ammonium persulfate, potassium persulfate, benzoyl peroxide, tert-butyl benzoyl peroxide, methyl ethyl ketone peroxide, dibenzoyl peroxide, N,N-dimethylaniline, or dimethyl-β-propiothetin.

7. The photopolymer according to claim 6, **characterized in that** in percentage by mass, the matrix comprises:
69.4% of the methyl methacrylate,
6% of the butyl acrylate,
0% of the hydroxyethyl methacrylate,
13.6% of the isobornyl methacrylate,
10% of the dodecafluoroheptyl methacrylate,
0.7% of the dibenzoyl peroxide, and
0.7% of N,N-dimethyl-p-toluidine.

8. A non-film-forming matrix for a photopolymer, **characterized by** comprising, in percentage by mass, 30-70% of a matrix and 30-70% of a solvent 1, wherein the matrix comprises:
40-85% of methyl methacrylate,
0-50% of a low-Tg acrylic monomer,
0-20% of a cross-linked acrylic monomer,
5-20% of a rigid pendant group monomer,
4-20% of a fluorine-containing or silicon-containing acrylic monomer, and
0.5-5% of a free radical thermal initiator.

9. A photopolymer film, **characterized by** comprising the photopolymer according to any one of claims 2 to 6 and two layers of protective films, wherein the two layers of protective films respectively cover both sides of the photopolymer.

10. A photopolymer printing stock, **characterized by** comprising a printing stock and the photopolymer according to any one of claims 2 to 6, wherein the photopolymer is cured onto the printing stock and carries a volume holographic grating.
